# EUROPEAN PATENT APPLICATION

(11) **EP 4 554 334 A1**
(43) Date of publication of application: **14.05.2025**
(21) Application number: 24211737.2
(22) Date of filing: 08.11.2024
(51) Int. Cl.: H05H 1/34, H05H 1/48

(54) **PLASMA PROCESSING APPARATUS**

(30) Priority: 10.11.2023 JP 2023192270
(71) Applicant: DAIHEN Corporation, Yodogawa-ku Osaka-shi, Osaka 532-8512 (JP)
(72) Inventor: Tamaki, Ryoji, Osaka, 532-8512 (JP); Hasegawa, Shinichi, Osaka, 532-8512 (JP)
(74) Representative: Hoffmann Eitle

(57) **Abstract**

A plasma processing apparatus (1) includes: an inner electrode (100); an electrode holder (200); an outer electrode (400) formed in a cylindrical shape, the outer electrode surrounding the inner electrode and the electrode holder; an insulating pipe (500) disposed between the inner electrode and the outer electrode and between the electrode holder and the outer electrode, the insulating pipe surrounding the inner electrode and the electrode holder; a rotary cylindrical portion (600) made of an insulating material and formed in a cylindrical shape surrounding the outer electrode, the rotary cylindrical portion being rotatable relative to the outer electrode about a central axis (AX) of the inner electrode; and a drive mechanism (700) that rotates the rotary cylindrical portion.

## Description

### CROSS REFERENCE TO RELATED APPLICATIONS

This nonprovisional application is based on Japanese Patent Application No. 2023-192270 filed on November 10, 2023 with the Japan Patent Office, the entire contents of which are hereby incorporated by reference.

### BACKGROUND OF THE INVENTION

### Field of the Invention

The present disclosure relates to a plasma processing apparatus.

### Description of the Background Art

Conventionally, in a torch used for plasma processing of the surface of a workpiece such as a synthetic resin, it is known that a nozzle of the torch that applies plasma is rotated for such purposes as conforming to the shape of the workpiece. For example, Japanese Patent Laying-Open No. 2001-68298 discloses a plasma nozzle including: an electrode; and a casing rotatable relative to a supporting tube disposed around the electrode. The casing is made of metal, and electrical discharge occurs between the electrode and the casing upon application of a voltage to the electrode. When the casing rotates about its axis, a plasma jet draws the generatrix of a cone, which is applied to the surface of a workpiece.

### SUMMARY OF THE INVENTION

In the plasma nozzle described in Japanese Patent Laying-Open No. 2001-68298, there is a risk of contact with the casing that rotates relative to the inner electrode because this casing is electrically charged.

An object of the present disclosure is to provide a plasma processing apparatus which does not require an electrically conductive bearing (a slip ring) or an electric brush for rotating an electrically charged casing, has a simple structure, is inexpensive, and is capable of reducing a risk associated with contact with a rotary cylindrical portion.

A plasma processing apparatus according to one aspect of the present disclosure includes: an inner electrode that receives application of a voltage; an electrode holder that holds the inner electrode; an outer electrode formed in a cylindrical shape, the outer electrode surrounding the inner electrode and the electrode holder; an insulating pipe disposed between the inner electrode and the outer electrode and between the electrode holder and the outer electrode, the insulating pipe surrounding the inner electrode and the electrode holder; a rotary cylindrical portion made of an insulating material and formed in a cylindrical shape surrounding the outer electrode, the rotary cylindrical portion being rotatable relative to the outer electrode about a central axis of the inner electrode; and a drive mechanism that rotates the rotary cylindrical portion.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a cross-sectional perspective view of a plasma processing apparatus in one embodiment of the present disclosure.
Fig. 2 is a cross-sectional view showing a tip end portion of the plasma processing apparatus.

### DESCRIPTION OF THE PREFERRED EMBODIMENTS

Embodiments of the present disclosure will be described with reference to the drawings. In the drawings referenced below, the same or corresponding members are denoted by the same numerals.

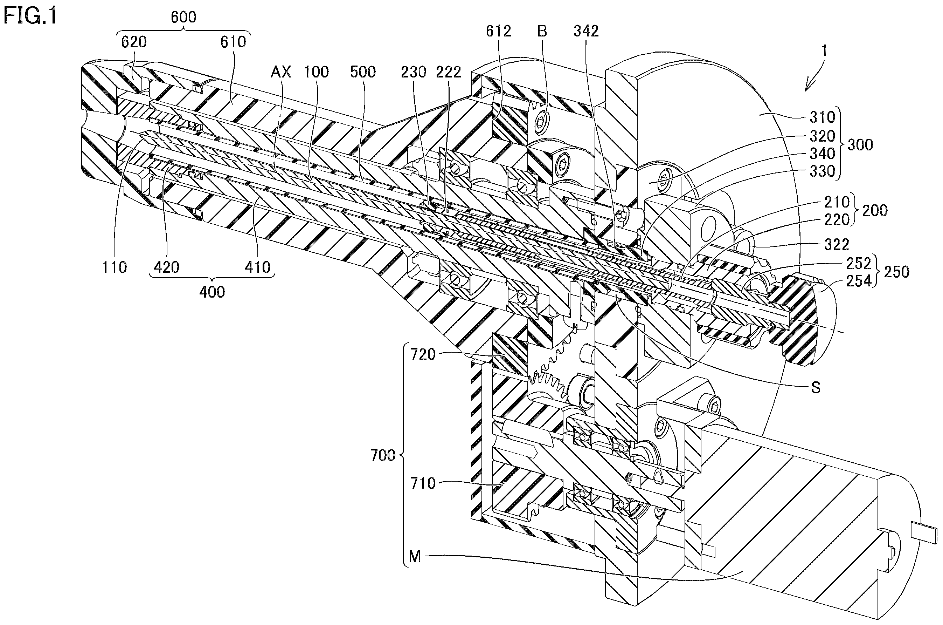

Fig. 1 is a cross-sectional perspective view of a plasma processing apparatus in one embodiment of the present disclosure. This plasma processing apparatus 1 is suitably used for surface modification of a workpiece, and is also suitably used for TIG welding.

As shown in Fig. 1, plasma processing apparatus 1 includes an inner electrode 100, an electrode holder 200, a position adjustment member 250, a support 300, an outer electrode 400, an insulating pipe 500, a rotary cylindrical portion 600, and a drive mechanism 700.

Inner electrode 100 has a linearly extending shape. Inner electrode 100 is made of, for example, tungsten. A voltage is applied to inner electrode 100 from a power supply which is not shown.

Electrode holder 200 holds inner electrode 100. Electrode holder 200 includes an inner holder 210, an outer holder 220, and a fin member 230.

Inner holder 210 holds inner electrode 100 while contacting an outer circumferential surface of inner electrode 100. Inner holder 210 has a shape extending along a direction parallel to a central axis AX of inner electrode 100. Inner holder 210 is made of, for example, copper. A tip end portion of inner holder 210 is provided with a slit extending in a direction parallel to the axial direction of inner holder 210.

Outer holder 220 surrounds inner holder 210. An inner circumferential surface of a tip end portion of outer holder 220 is provided with a reduced-diameter portion that is gradually reduced in diameter toward the tip end. Therefore, when inner holder 210 is inserted into outer holder 220, the tip end portion of inner holder 210 is pressed by the reduced-diameter portion of outer holder 220 and is thereby pressed into contact with inner electrode 100. A base end portion of outer holder 220 is provided with an internal thread.

Position adjustment member 250 can adjust the position of inner electrode 100 relative to electrode holder 200. Position adjustment member 250 includes an adjustment portion 252 and a knob 254.

Adjustment portion 252 is axially movable relative to outer holder 220. Specifically, adjustment portion 252 is provided with an external thread to be engaged with the internal thread provided on the base end portion of outer holder 220. Adjustment portion 252 can adjust the position of inner electrode 100 relative to electrode holder 200 by adjusting a force (a pushing force) that axially biases inner holder 210 relative to outer holder 220.

For example, when adjustment portion 252 is screwed into outer holder 220 with a tip end portion of adjustment portion 252 contacting a base end portion of inner holder 210, the tip end portion of inner holder 210 is biased toward inner electrode 100 by the reduced-diameter portion of outer holder 220. As a result, the tip end portion of inner holder 210 is pressed into contact with inner electrode 100, so that the position of inner electrode 100 relative to electrode holder 200 is determined.

Conversely, when adjustment portion 252 is separated from inner holder 210, the biasing of inner holder 210 by the reduced-diameter portion of outer holder 220 is released, so that inner electrode 100 can be moved relative to electrode holder 200, that is, the position of inner electrode 100 relative to electrode holder 200 can be changed.

Knob 254 is connected to a base end portion of adjustment portion 252. Knob 254 is connected to the base end portion of adjustment portion 252 so as not to rotate relative to adjustment portion 252. Adjustment portion 252 and knob 254 may be integrally formed of the same material.

Support 300 supports electrode holder 200. Support 300 includes a support plate 310, an insulating plate 320, a block portion 330, and an interposed member 340.

Support plate 310 is formed in a disc shape. Support plate 310 is made of, for example, metal such as aluminum. Note that support plate 310 may be made of an insulating material.

Insulating plate 320 is disposed in an opening provided in support plate 310. Electrode holder 200 is disposed to extend through insulating plate 320. Insulating plate 320 includes a gas introduction portion 322 (described later).

Block portion 330 is secured to insulating plate 320 by a fastening member such as a screw. Block portion 330 is secured to insulating plate 320 from one side in the direction parallel to central axis AX of inner electrode 100. Block portion 330 is made of an electrically conductive material. Electrode holder 200 is disposed to extend through block portion 330. Specifically, block portion 330 has an inner circumferential surface that is in contact with outer holder 220.

Interposed member 340 is made of an insulating material and interposed between outer holder 220 and insulating plate 320. As shown in Fig. 1, an outer circumferential surface of interposed member 340 is provided with a recess 342. Recess 342 extends annularly and continuously about central axis AX. This recess 342 forms a space S between insulating plate 320 and interposed member 340.

Outer electrode 400 is formed in a cylindrical shape, more specifically, in a circular cylindrical shape. Outer electrode 400 surrounds inner electrode 100 and electrode holder 200. Outer electrode 400 includes an outer electrode body 410 and a power feeding chip 420.

Outer electrode body 410 is secured to support 300 from the other side in the direction parallel to central axis AX of inner electrode 100. In other words, block portion 330 and outer electrode body 410 are secured to insulating plate 320 so as to sandwich insulating plate 320 from both sides in the direction parallel to central axis AX.

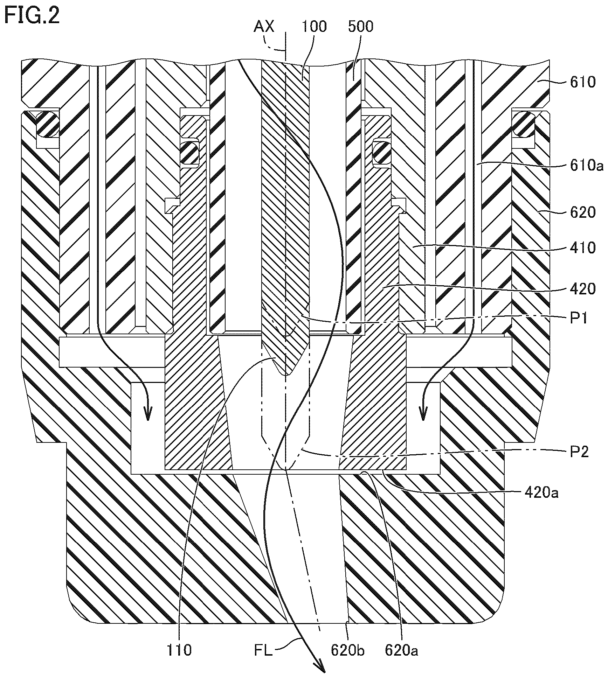

Power feeding chip 420 is connected to a tip end portion of outer electrode body 410. Power feeding chip 420 includes a tip end surface 420a located in the same plane as a tip end portion 110 of inner electrode 100, or located ahead of tip end portion 110 (see Fig. 2). Tip end surface 420a is orthogonal to central axis AX.

Insulating pipe 500 is disposed between inner electrode 100 and outer electrode 400 and between electrode holder 200 and outer electrode 400. Insulating pipe 500 surrounds inner electrode 100 and electrode holder 200. Insulating pipe 500 is formed in a circular cylindrical shape. Insulating pipe 500 is made of ceramic or the like. Insulating pipe 500 is sandwiched from both sides in the direction parallel to central axis AX by power feeding chip 420 of outer electrode 400 and interposed member 340 of support 300.

A process gas (such as argon or air) is supplied into insulating pipe 500 from a gas supply portion which is not shown. The gas supply portion supplies the process gas to gas introduction portion 322 provided on insulating plate 320. Insulating plate 320 is provided with a gas flow path extending from gas introduction portion 322 to space S, and interposed member 340 is provided with a through hole. Therefore, the process gas that has been supplied from the gas supply portion flows through gas introduction portion 322, the gas flow path, and the through hole in interposed member 340, into a space between outer holder 220 and insulating pipe 500.

Fin member 230 serves to cause the process gas that has been supplied to the inside of insulating pipe 500 to swirl, to thereby form a swirling flow FL around inner electrode 100 (see Fig. 2). Fin member 230 is connected to a tip end portion 222 of outer holder 220. More specifically, fin member 230 is fit to tip end portion 222 of outer holder 220 from the outer circumferential side of tip end portion 222. An outer circumferential surface of fin member 230 is provided with a plurality of helical grooves. The outer circumferential surface of fin member 230 may be in contact with an inner circumferential surface of insulating pipe 500, or may be separated from the inner circumferential surface of insulating pipe 500. Note that the outer circumferential surface of fin member 230 is preferably in contact with the inner circumferential surface of insulating pipe 500. Fin member 230 is separated from the outer circumferential surface of inner electrode 100.

The process gas that has been supplied to the inside of insulating pipe 500 is converted into a plasma state in the vicinity of tip end portion 110 of inner electrode 100. Insulating pipe 500 defines a position where plasma is generated between inner electrode 100 and outer electrode 400. As shown in Fig. 2, tip end portion 110 of inner electrode 100 is movable between a retracted position P1 flush with a tip end surface of insulating pipe 500 and a protruding position P2 flush with tip end surface 420a of power feeding chip 420. Stated another way, electrode holder 200 holds inner electrode 100 such that tip end portion 110 of inner electrode 100 is movable between retracted position P1 and protruding position P2.

As shown in Figs. 1 and 2, the position of tip end portion 110 of inner electrode 100 may be set to a position exposed at insulating pipe 500. In the example shown in Fig. 2, the position of tip end portion 110 is set between retracted position P1 and protruding position P2.

Rotary cylindrical portion 600 is formed in a cylindrical shape surrounding outer electrode 400. Rotary cylindrical portion 600 is rotatable relative to outer electrode 400 about central axis AX. Rotary cylindrical portion 600 is made of an insulating material. In the present embodiment, rotary cylindrical portion 600 includes a rotary cylindrical portion body 610 and a rotary nozzle 620.

Rotary cylindrical portion body 610 is disposed around outer electrode body 410. A bearing is disposed between rotary cylindrical portion body 610 and outer electrode body 410. Rotary cylindrical portion body 610 is made of, for example, polyetheretherketone (PEEK resin).

Rotary nozzle 620 is connected to a tip end portion of rotary cylindrical portion body 610 so as not to rotate relative to rotary cylindrical portion body 610. Rotary nozzle 620 is a portion that blows swirling flow FL that has been converted into a plasma state. As shown in Fig. 2, an opening (a plasma outlet port) 620b of rotary nozzle 620 may be eccentric with respect to central axis AX of inner electrode 100. Rotary nozzle 620 is made of, for example, polyetheretherketone (PEEK resin). As shown in Fig. 2, rotary nozzle 620 has a facing surface 620a facing tip end surface 420a of power feeding chip 420.

As shown in Fig. 2, rotary cylindrical portion body 610 may be provided with a supply flow path 610a for supplying a gas from the outside of outer electrode 400 toward a space between tip end surface 420a and facing surface 620a. Alternatively, at least one of tip end surface 420a and facing surface 620a may be provided with an annular groove, and a seal member such as an O ring may be provided in the groove.

Drive mechanism 700 rotates rotary cylindrical portion 600. Drive mechanism 700 includes a motor M, and a power transmission unit that transmits an output of motor M to rotary cylindrical portion 600. In the present embodiment, the power transmission unit includes a first gear 710 and a second gear 720. Note that the power transmission unit may be implemented by, for example, a belt, a pulley, a roller chain, or a sprocket. A power source that generates a rotational force such as a gasoline engine, a diesel engine, or a rotary cylinder may be used in place of motor M.

Motor M is secured to support plate 310. Motor M has an output shaft extending through support plate 310.

First gear 710 is connected to the output shaft of motor M.

Second gear 720 is disposed to mesh with first gear 710. Second gear 720 is disposed to surround outer electrode 400. Second gear 720 has a center of rotation located on central axis AX.

As shown in Fig. 1, rotary cylindrical portion body 610 of rotary cylindrical portion 600 has a receiving surface 612 that receives second gear 720 in the direction parallel to central axis AX. Second gear 720 is secured to rotary cylindrical portion body 610 by a fastening member B that exerts an axial force that presses second gear 720 against receiving surface 612.

In plasma processing apparatus 1 described above, when a process gas is supplied to the inside of insulating pipe 500 from the gas supply portion (not shown), the process gas is turned into swirling flow FL around inner electrode 100 by passing through the grooves of fin member 230, and is converted into a plasma state in the vicinity of tip end portion 110 of inner electrode 100. When motor M of drive mechanism 700 is driven, on the other hand, rotary cylindrical portion body 610 and rotary nozzle 620 rotate relative to inner electrode 100 and outer electrode 400 about central axis AX via first gear 710 and second gear 720. This makes it possible, for example, to apply plasma conforming to the shape of a workpiece to the workpiece.

As described above, in plasma processing apparatus 1 according to the present embodiment, rotary cylindrical portion 600 is made of an insulating material, so that a risk associated with contact with rotary cylindrical portion 600 is reduced and safety is enhanced as compared to when rotary cylindrical portion 600 is made of an electrically conductive material (such as metal).

It will be understood by those skilled in the art that the plurality of exemplary embodiments described above are specific examples of the following aspects.

[Aspect 1] A plasma processing apparatus comprising:
an inner electrode that receives application of a voltage;
an electrode holder that holds the inner electrode;
an outer electrode formed in a cylindrical shape, the outer electrode surrounding the inner electrode and the electrode holder;
an insulating pipe disposed between the inner electrode and the outer electrode and between the electrode holder and the outer electrode, the insulating pipe surrounding the inner electrode and the electrode holder;
a rotary cylindrical portion made of an insulating material and formed in a cylindrical shape surrounding the outer electrode, the rotary cylindrical portion being rotatable relative to the outer electrode about a central axis of the inner electrode; and
a drive mechanism that rotates the rotary cylindrical portion.

In this plasma processing apparatus, the rotary cylindrical portion is made of an insulating material, so that a risk associated with contact with the rotary cylindrical portion is reduced as compared to when the rotary cylindrical portion is made of an electrically conductive material (such as metal).

[Aspect 2] The plasma processing apparatus according to aspect 1, further comprising a support that supports the electrode holder and the outer electrode, wherein
the electrode holder is secured to the support from one side in a direction parallel to the central axis, and
the outer electrode is secured to the support from the other side in the direction parallel to the central axis.

[Aspect 3] The plasma processing apparatus according to aspect 2, wherein the insulating pipe is sandwiched from both sides in the direction parallel to the central axis by the outer electrode and the support.

In this aspect, the position of the insulating pipe is determined, so that the position where plasma is generated is effectively defined.

[Aspect 4] The plasma processing apparatus according to aspect 1, wherein the drive mechanism includes
a motor,
a first gear connected to an output shaft of the motor, and
a second gear disposed to mesh with the first gear,

the second gear is disposed to surround the outer electrode,
the rotary cylindrical portion has a receiving surface that receives the second gear in a direction parallel to the central axis, and
the second gear is secured to the rotary cylindrical portion by a fastening member that exerts an axial force that presses the second gear against the receiving surface.

In this aspect, the second gear is secured to the rotary cylindrical portion by the fastening member, so that freewheeling and the like of the second gear portion relative to the rotary cylindrical portion is suppressed.

[Aspect 5] The plasma processing apparatus according to aspect 1, wherein the electrode holder holds the inner electrode such that a tip end portion of the inner electrode is movable between a retracted position flush with a tip end surface of the insulating pipe and a protruding position flush with a tip end surface of the outer electrode.

[Aspect 6] The plasma processing apparatus according to aspect 5, wherein the rotary cylindrical portion has
a facing surface facing the tip end surface of the outer electrode, and
a supply flow path for supplying a gas from an outside of the outer electrode toward a space between the tip end surface of the outer electrode and the facing surface.

In this aspect, a gas is supplied to the supply flow path, so that the process gas that has been supplied between the inner electrode and the insulating pipe is inhibited from flowing to the outside of the outer electrode through the space between the tip end surface of the outer electrode and the facing surface.

Although the embodiments of the present invention have been described, it should be understood that the embodiments disclosed herein are illustrative and nonrestrictive in every respect. The scope of the present invention is defined by the terms of the claims, and is intended to include any modifications within the scope and meaning equivalent to the terms of the claims.

## Claims

1. A plasma processing apparatus (1) comprising:
an inner electrode (100) that receives application of a voltage;
an electrode holder (200) that holds the inner electrode (100);
an outer electrode (400) formed in a cylindrical shape, the outer electrode (400) surrounding the inner electrode (100) and the electrode holder (200);
an insulating pipe (500) disposed between the inner electrode (100) and the outer electrode (400) and between the electrode holder (200) and the outer electrode (400), the insulating pipe (500) surrounding the inner electrode (100) and the electrode holder (200);
a rotary cylindrical portion (600) made of an insulating material and formed in a cylindrical shape surrounding the outer electrode (400), the rotary cylindrical portion (600) being rotatable relative to the outer electrode (400) about a central axis (AX) of the inner electrode (100); and
a drive mechanism (700) that rotates the rotary cylindrical portion (600).

2. The plasma processing apparatus (1) according to claim 1, further comprising a support (300) that supports the electrode holder (200) and the outer electrode (400), wherein
the electrode holder (200) is secured to the support (300) from one side in a direction parallel to the central axis, and
the outer electrode (400) is secured to the support (300) from the other side in the direction parallel to the central axis.

3. The plasma processing apparatus (1) according to claim 2, wherein the insulating pipe (500) is sandwiched from both sides in the direction parallel to the central axis (AX) by the outer electrode (400) and the support (300).

4. The plasma processing apparatus (1) according to any one of the preceding claims, wherein
the drive mechanism (700) includes
a motor (M),
a first gear (710) connected to an output shaft of the motor, and
a second gear (720) disposed to mesh with the first gear (710),
the second gear (720) is disposed to surround the outer electrode (400),
the rotary cylindrical portion (600) has a receiving surface (612) that receives the second gear (720) in a direction parallel to the central axis, and
the second gear (720) is secured to the rotary cylindrical portion (600) by a fastening member (B) that exerts an axial force that presses the second gear (720) against the receiving surface (612).

5. The plasma processing apparatus (1) according to any one of the preceding claims, wherein the electrode holder (200) holds the inner electrode (100) such that a tip end portion (110) of the inner electrode (100) is movable between a retracted position flush with a tip end surface of the insulating pipe (500) and a protruding position flush with a tip end surface (420a) of the outer electrode (400).

6. The plasma processing apparatus (1) according to claim 5, wherein the rotary cylindrical portion (600) has
a facing surface (620a) facing the tip end surface (420a) of the outer electrode (400), and
a supply flow path (610a) for supplying a gas from an outside of the outer electrode (400) toward a space between the tip end surface (420a) of the outer electrode (400) and the facing surface (620a).
